# EUROPEAN PATENT APPLICATION

(11) **EP 4 498 201 A1**
(43) Date of publication of application: **29.01.2025**
(21) Application number: 23799424.9
(22) Date of filing: 05.04.2023
(51) Int. Cl.: G05D 1/02

(54) **TRAVELING VEHICLE SYSTEM**

(30) Priority: 02.05.2022 JP 2022076126
(71) Applicant: Murata Machinery, Ltd., Kyoto-shi, Kyoto 601-8326 (JP)
(72) Inventor: HARASAKI Kazumi, Inuyama-shi, Aichi 484-8502 (JP)
(74) Representative: Stöckeler, Ferdinand
(86) International application number: PCT/JP2023/014112
(87) International publication number: WO 2023/214492

(57) **Abstract**

A traveling vehicle system (1) includes: a track (11), a plurality of traveling vehicles (5); and a control unit (3) configured to control each of the traveling vehicles (5). A portion of a traveling area for the traveling vehicles (5) is shut off by a shutter (83) configured to be activated upon detection of an anomaly by a detection device (81). The control unit (3) permits the traveling vehicles (5) to enter an interference section (A1) without checking the presence or absence of the traveling vehicles (5) in the interference section (A1) upon determining that the number of the traveling vehicles (5) present in a lock section (A2) has not reached a specified number (N) of two or more, and prohibits the traveling vehicles (5) from entering the interference section (A1) upon determining that the specified number (N) has been reached.

## Description

### Technical Field

An aspect of the present invention relates to a traveling vehicle system.

### Background Art

A traveling vehicle system is known in which a traveling vehicle configured to transport a container such as a front opening unified pod (FOUP) or a reticle pod in which objects to be stored such as semiconductor wafers or glass substrates are stored travels along a track. A building in which such a traveling vehicle system is disposed may be provided with shutters configured to operate to partition spaces in the building in an emergency to prevent a fire from entering and spreading. In this case, the track is disposed to straddle an area shielded by the shutters.

In such a traveling vehicle system, if an activated shutter catches a traveling vehicle, the space in the building cannot be partitioned and the shutter cannot function properly. In view of this, for example, an area where a traveling vehicle may be caught when the shutter is activated is set as a blocking area, and blocking control is performed to reduce the number of traveling vehicles present in the blocking area to one or less. This can reduce the possibility that the activated shutter will catch a traveling vehicle.

### Citation List

### Patent Literature

Patent Document 1: Japanese Patent No. 5071695

### Summary of Invention

### Technical Problem

However, such blocking control requires time to determine the presence or absence of traveling vehicles in the blocking area or to control permission to enter the blocking area, which may reduce the transport efficiency of the traveling vehicles.

In view of this, it is an object of an aspect of the present invention to provide a traveling vehicle system that can cause an activated shutter to function properly while suppressing a reduction in transport efficiency.

### Solution to Problem

A traveling vehicle system according to an aspect of the present invention is a traveling vehicle system comprising: a track; a plurality of traveling vehicles configured to travel along the track in one direction; and a control unit configured to control each of the traveling vehicles, wherein a portion of a traveling area for the traveling vehicles is shut off by a shutter configured to be activated upon detection of an anomaly by a detection device. The control unit sets as an interference section a section of the track that includes at least a presence area of the traveling vehicles with which the shutter activated upon detection of the anomaly comes into contact, and sets as a lock section a section being adjacent downstream of the interference section in the one direction and having a section length in which two or more of the traveling vehicles are able to be present. Further permits the traveling vehicles to enter the interference section upon determining that the number of the traveling vehicles present in the lock section has not reached a specified number of two or more, and prohibits the traveling vehicles from entering the interference section upon determining that the specified number has been reached.

In the traveling vehicle system thus configured, the traveling vehicles are permitted to continuously enter the interference section until the number of traveling vehicles present in the lock section reaches the specified number. This can increase the number of traveling vehicles that are allowed to enter the interference section per unit of time. In the traveling vehicle system thus configured, when the number of traveling vehicles present in the lock section has reached the specified number, traveling vehicles are prohibited from entering the interference section. By this control, a traveling vehicle that cannot enter the lock section will not stay in the interference section, and thus the activated shutter can be prevented from catching the traveling vehicle. Consequently, the activated shutter can function properly while suppressing a reduction in transport efficiency.

In the traveling vehicle system according to an aspect of the present invention, the control unit may permit the traveling vehicles to enter the interference section without checking the presence or absence of the traveling vehicles in the interference section. In the traveling vehicle system thus configured, the number of traveling vehicles that are allowed to enter the interference section per unit of time can be increased in comparison with conventional blocking control of checking the presence or absence of the traveling vehicles in the interference section and then allowing the traveling vehicles to enter the interference section.

In the traveling vehicle system according to an aspect of the present invention, the shutter may have a time lag between shutting off the traveling area and detecting the anomaly, and the interference section may be set so that the traveling vehicles are able to travel through the interference section during the time lag. In the traveling vehicle system thus configured, when an anomaly has been detected while a traveling vehicle is passing through the interference section, the traveling vehicle can be more reliably ejected from the interference section.

In the traveling vehicle system according to an aspect of the present invention, a boundary between the interference section and the lock section may be set at a position where the traveling vehicles are able to travel through the interference section during the time lag, a deceleration point for the traveling vehicles or a stop point for the traveling vehicles may be set on the track further downstream in the one direction than a portion of the traveling area shut off by the shutter, and the lock section may be set to be a section between the boundary and the deceleration point or a section between the boundary and the stop point. In the traveling vehicle system thus configured, even when the point where congestion of traveling vehicles is likely to occur is located downstream of the portion shut off by the shutter, the activated shutter can function properly while suppressing the reduction in transport efficiency.

In the traveling vehicle system according to an aspect of the present invention, the deceleration point or the stop point may be set at a branch point where the track branches in two or more directions. In the traveling vehicle system thus configured, even when the branch point where congestion of the traveling vehicles is likely to occur is located downstream of the portion shut off by the shutter, the activated shutter can function properly while suppressing the reduction in transport efficiency.

In the traveling vehicle system according to an aspect of the present invention, the detection device may be a fire detection device configured to detect a fire, and the shutter may be a fire door. In the traveling vehicle system thus configured, even if the fire door configured to be activated upon detection of an anomaly by the fire detection device is configured to shut off the traveling area, the activated shutter can function properly while suppressing the reduction in transport efficiency.

### Advantageous Effects of Invention

According to an aspect of the present invention, the activated shutter can function properly while suppressing the reduction in transport efficiency.

### Brief Description of Drawings

[FIG. 1] FIG. 1 is a schematic diagram illustrating a configuration of a traveling vehicle system according to an embodiment.
[FIG. 2] FIG. 2 is a functional block diagram illustrating a functional configuration of the traveling vehicle system in FIG. 1.
[FIG. 3] FIG. 3 is a sequence diagram of a traveling vehicle control at the time of entry into an interference section.
[FIG. 4] FIG. 4 is a sequence diagram of the traveling vehicle control when a fire door is activated.

### Description of Embodiments

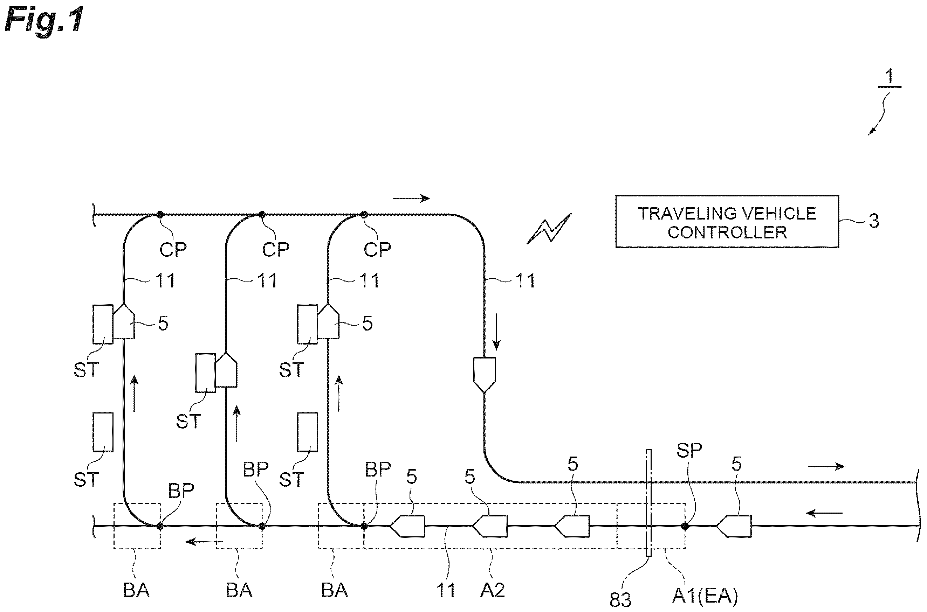

An embodiment will be described below with reference to the drawings. In the description of the drawings, identical constituent elements will be denoted by identical reference signs and redundant explanations will be omitted. The dimensional proportions in the drawings do not necessarily match those in the description. The terms "upstream" and "downstream" when the embodiment is described mean upstream and downstream in a predetermined traveling direction (the arrow directions indicated along tracks 11 illustrated in FIG. 1: one direction) of an overhead traveling vehicle (traveling vehicle) 5 (hereinafter, simply referred to as "traveling vehicle 5").

A traveling vehicle system 1 is a system configured to transport an article by using the overhead traveling vehicle 5 capable of moving along the tracks 11. The traveling vehicle 5 is an automated traveling vehicle, and examples thereof include an overhead traveling vehicle and a rail-guided vehicle. Herein, the traveling vehicle system 1 in which the traveling vehicle 5 travels in a building of a factory or the like along one-way tracks 11 installed on a ceiling or the like of the building will be described as an example. As illustrated in FIG. 1, the traveling vehicle system 1 mainly includes the tracks 11, a plurality of stations ST, a plurality of the traveling vehicles 5, and a traveling vehicle controller (control unit) 3.

The tracks 11 are members on which the traveling vehicles 5 travel and are suspended from the ceiling. FIG. 1 illustrates an example of a layout of the tracks 11 in the present embodiment. The tracks 11 in the present embodiment are set such that the traveling vehicles 5 travel one way in the arrow directions illustrated in FIG. 1. On the tracks 11, branch points BP where the tracks 11 branch and merging points CP where the tracks 11 merge are provided.

The stations ST are provided in a manner facing the tracks 11. Each station ST is a part where an article is delivered to and from a traveling vehicle 5. Examples of the station ST in a semiconductor processing plant include a load port for delivering a FOUP between a semiconductor processing device and a traveling vehicle 5 and a buffer on which the traveling vehicle 5 can temporarily place the FOUP.

The building in which the traveling vehicle system 1 is disposed is provided with a fire detection device (detection device) 81 and a fire door (shutter) 83. The fire detection device 81 detects a fire that has broken out in the building. When having detected a fire, the fire detection device 81 transmits a detection signal to the traveling vehicle controller 3 and also activates the fire door 83 to partition a space in the building. The fire door 83 is provided to prevent a fire from entering and prevent the spread of fire. The fire door 83 is disposed in a retreat position, for example, on the ceiling, a side wall, or a floor of the building, and is configured to advance from the retreat position to an advance position at the time of an anomaly.

The fire door 83 that has advanced from the retreat position (the fire door 83 when activated) shuts off a portion of the traveling area for the traveling vehicles 5 along the tracks 11. The fire door 83 completes advancing to the advance position 30 seconds after receiving the detection signal transmitted from the fire detection device 81. In other words, the fire door 83 has a time lag of about 30 seconds from the time when a fire has been detected by the fire detection device 81 to the time when it shuts off the traveling area for the traveling vehicles 5 (partitions the space). More specifically, the fire door 83 starts operating in a predetermined time (e.g., 10 seconds) after having received the detection signal, and completes advancing to the advance position in a predetermined time (e.g., 20 seconds) after having started operating. The time of the time lag disclosed above is an example and may be less than 30 seconds or longer than 30 seconds. The time after receipt of the detection signal until the fire door 83 starts operating does not have to be ensured.

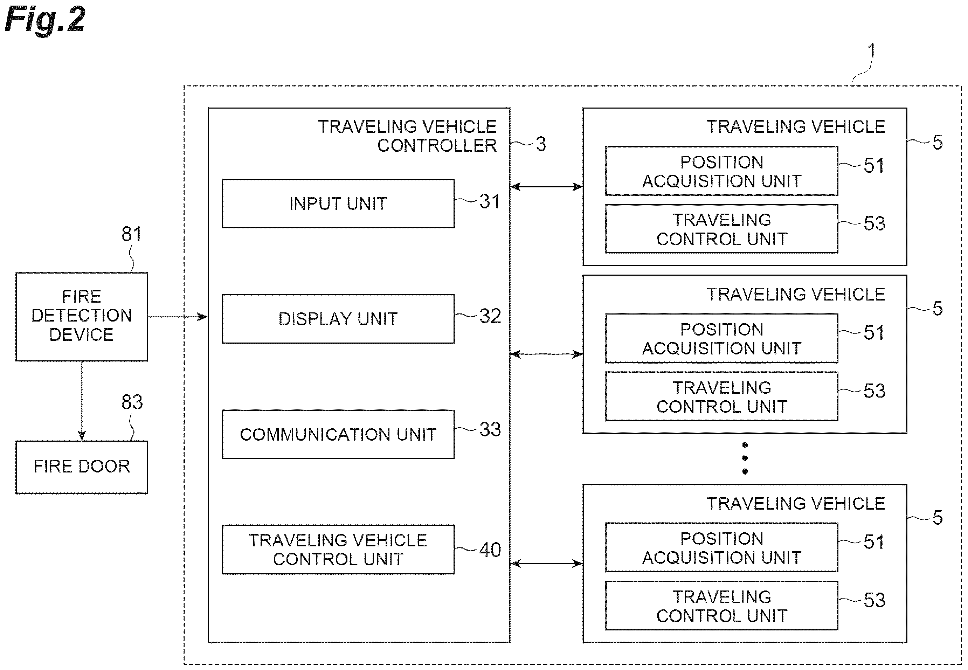

The traveling vehicle controller 3 includes an input unit 31, a display unit 32, a communication unit 33, and a traveling vehicle control unit 40 as illustrated in FIG. 2. The input unit 31 includes a keyboard and a mouse, for example, and is a unit used by a user to input various operations and various setting values. In the present embodiment, the setting of a specified number N of vehicles in the lock section A2, which is described later in detail, and other settings are set by input from the input unit 31. The display unit 32 includes a liquid crystal display, for example, and is a unit configured to display various setting screens and input screens to be input by the input unit 31, for example. The input unit 31 and the display unit 32 do not need to be provided integrally with the traveling vehicle controller 3, and can be substituted by terminal devices that can communicate with each other.

The communication unit 33 is a unit configured to communicate with other devices and the like and, for example, transmits a transport command to each traveling vehicle 5 and receives information (position data) on the current position of the traveling vehicle 5 via a wireless communication network. The communication unit 33 also receives a transport command including information on a station ST as a destination, from a higher-level controller via a local area network (LAN), for example.

The traveling vehicle control unit 40 is a unit configured to perform various control processes in the traveling vehicle system 1, which is described later in detail, and includes a CPU, a ROM, a RAM, and the like. As illustrated in FIG. 2, the traveling vehicle control unit 40 can be configured, for example, as software that is a program stored in the ROM, loaded into the RAM, and executed by the CPU. The traveling vehicle control unit 40 may be configured as hardware with electronic circuitry, for example.

The traveling vehicle control unit 40 controls the traveling of the traveling vehicle 5 on the basis of a transport command transmitted from, for example, a higher-level controller (not illustrated). The traveling vehicle control unit 40 also ascertains the position of each traveling vehicle 5 on the basis of the position information (described later in detail) periodically or continuously transmitted from the traveling vehicle 5. The traveling vehicle control unit 40 sets as an interference section A1 a section, of the tracks 11, that includes at least a presence area EA of a traveling vehicle 5 with which the fire door 83 activated upon detection of an anomaly comes into contact, and sets as a lock section A2 a section that is adjacent downstream of the interference section A1 in one direction and where two or more traveling vehicles 5 can be present.

The presence area EA here is an area the upstream end of which is the rear end position of a traveling vehicle 5 in a state in which the fire door 83 is in contact with the front end of the traveling vehicle 5 and the downstream end of which is the front end position of a traveling vehicle 5 in a state in which the fire door 83 is in contact with the rear end of the traveling vehicle 5. The interference section A1 in the present embodiment is formed only by the presence area EA of a traveling vehicle 5 with which the fire door 83 activated upon detection of an anomaly comes into contact. The interference section A1 only needs to be a section that includes the presence area EA, and may be set longer upstream and/or downstream of the presence area EA.

In more detail, the interference section A1 is set so that, when a detection signal has been received from the fire detection device 81 as soon as a traveling vehicle 5 has entered the interference section A1, the traveling vehicle 5 can travel through the interference section A1 before the fire door 83 triggered to be activated by this reception finishes advancing to the advance position. In other words, the boundary between the interference section A1 and the lock section A2, which is a downstream end position of the interference section A1, is set at a position where the traveling vehicle 5 can travel through the interference section A1 during the time lag described above.

The meaning of the section where two or more traveling vehicles 5 can be present in the lock section A2 here includes not only having a section length in which two or more traveling vehicles 5 can be present with no space therebetween in the front and the rear in the traveling direction, but also having a section length in which two or more traveling vehicles 5 can be present with a predetermined space therebetween in the front and the rear in the traveling direction. The predetermined space therebetween in the front and the rear in the traveling direction is a minimum distance between the vehicles set in advance for each traveling vehicle system 1, and the traveling vehicles 5, 5 lined up behind each other are controlled such that the distance therebetween does not become the minimum distance or less.

For the traveling vehicle control unit 40 in the present embodiment, on the tracks 11 downstream, in the one direction, of the portion of the traveling area for the traveling vehicles 5 shut off by the fire door 83, a deceleration point for the traveling vehicles 5 or a stop point for the traveling vehicles 5 are set. Examples of configurations of the deceleration point for the traveling vehicles 5 or the stop point for the traveling vehicles 5 in the traveling vehicle system 1 include the branch points BP at each of which a track 11 branches into two or more, the merging points CP at each of which two or more tracks 11 merge, entry positions into curve sections, positions where the stations ST are disposed, and entry positions into blocking areas BA, for example.

In the present embodiment, each branch point BP where a track 11 branches into two or more is set as the stop point for a traveling vehicle 5. More specifically, the branch point BP is a position where the traveling vehicle 5 stops when the blocking control does not give permission to enter the corresponding blocking area BA. At a position in front of the branch point BP, the traveling vehicle 5 asks the traveling vehicle controller 3 for permission to enter the blocking area BA. The traveling vehicle controller 3 checks the presence or absence of a traveling vehicle 5 in the blocking area BA, and permits the traveling vehicle 5 to enter the blocking area BA only when having confirmed that no traveling vehicle 5 is present in the blocking area BA.

The lock section A2 is set to be located between the above-described boundary, which is set so that the traveling vehicle 5 can travel through the interference section A1 during the above-described time lag, and the deceleration point or the stop point described above. In the present embodiment, it is located between a branch point BP and the interference section A1.

The ranges of the interference section A1, the lock section A2, and the blocking areas BA described above are defined based on position information in the tracks 11 and are stored in a storage unit (not illustrated), for example. The traveling vehicle controller 3 stores map information storing the arrangement of the tracks 11 so that each position on the tracks 11 can be uniquely identified by the position information. To the tracks 11, bar codes or the like on which information corresponding to this position information is displayed are affixed so as to be able to be read by a scanner or the like provided to each traveling vehicle 5.

When having determined that the number of traveling vehicles 5 present in the lock section A2 has not reached the specified number N of two or more, the traveling vehicle control unit 40 permits a traveling vehicle 5 to enter the interference section A1 without checking the presence or absence of a traveling vehicle 5 in the interference section A1. When having determined that the specified number N has been reached, it prohibits the traveling vehicle 5 from entering the interference section A1. In the present embodiment, "three" is set as the above-described specified number N. Thus, when having determined that the number of traveling vehicles 5 present in the lock section A2 has not reached three, the traveling vehicle control unit 40 permits the traveling vehicle 5 to enter the interference section A1 without checking the presence or absence of traveling vehicles 5 in the interference section A1. When having determined that the number of traveling vehicles 5 in the lock section A2 has reached three, it prohibits the traveling vehicle 5 from entering the interference section A1.

Each traveling vehicle 5 is configured to be able to transfer an article. The traveling vehicle 5 includes a position acquisition unit 51 and a traveling control unit 53, as illustrated in FIG. 2, in addition to the known mechanisms configured to transfer an article.

The position acquisition unit 51 is a unit configured to acquire position information of the vehicle on the tracks 11. The position acquisition unit 51 may include, for example, a reading unit configured to read the bar codes or the like that are affixed to the tracks 11 and on which position information is displayed and an encoder or the like. The position acquisition unit 51 transmits, as position information, information on a point obtained by the reading unit and the travel distance after passing through the point obtained from the encoder to the traveling vehicle controller 3. The information acquired by the position acquisition unit 51 is transmitted to the traveling vehicle controller 3 in response to periodic or continuous inquiries from the traveling vehicle controller 3.

The traveling control unit 53 is a unit configured to control traveling of the traveling vehicle 5, which is an electronic control unit including a central processing unit (CPU), a read only memory (ROM), and a random access memory (RAM), for example. The traveling control unit 53 controls the traveling of the traveling vehicle 5 on the basis of a transport command transmitted from the traveling vehicle controller 3. The transport command transmitted from the higher-level controller (not illustrated) includes information on a station ST as a destination.

The traveling control unit 53 requests entry permission from the traveling vehicle controller 3 at specified positions. In the present embodiment, the upstream end SP of the interference section A1 and the branch points BP are set as the specified positions, and the traveling control unit 53 requests entry permission at the upstream end SP and the branch points BP from the traveling vehicle controller 3. The traveling control unit 53 may stop once at the upstream end SP and request entry permission, or may request the entry permission just before arriving at the upstream end SP. If the traveling control unit 53 cannot receive the entry permission from the traveling vehicle controller 3, the traveling vehicle 5 stops at the upstream end SP. Similarly, the traveling control unit 53 may stop once at each branch point BP and request entry permission, or may request the entry permission just before arriving at the branch point BP. If the traveling control unit 53 cannot receive the entry permission from the traveling vehicle controller 3, the traveling vehicle 5 stops at the branch point BP.

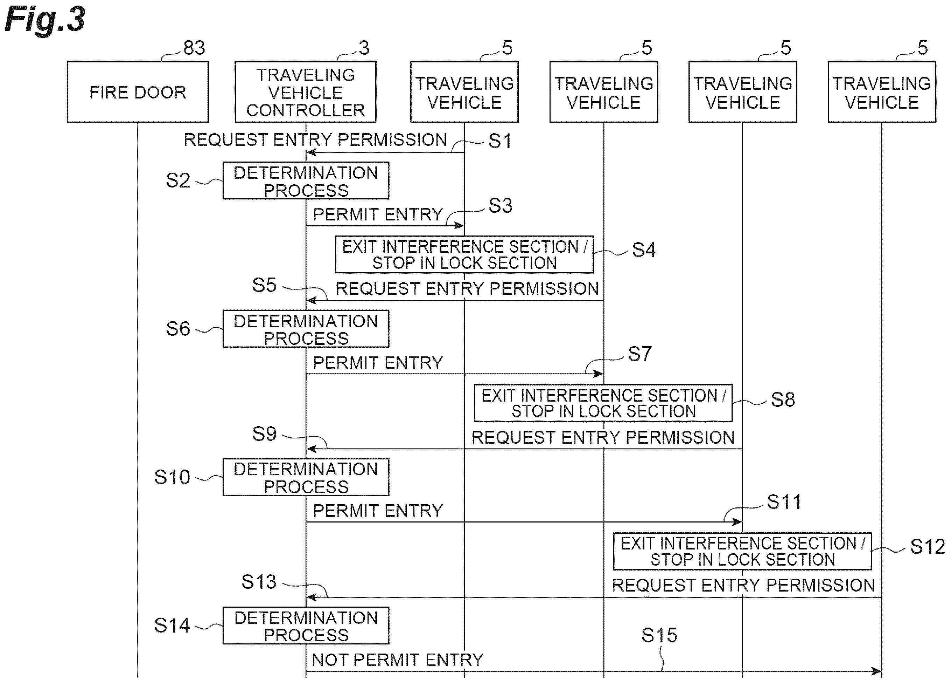

In the traveling vehicle system 1 thus configured, operation of each traveling vehicle 5 when the traveling vehicle controller 3 allows the traveling vehicle 5 to enter the interference section A1 will be described mainly with reference to FIG. 3. The following describes the operation of the traveling vehicle 5 from a state in which the number of traveling vehicles 5 in the lock section A2 is zero to a state in which it becomes three.

When the traveling vehicle 5 approaches the upstream end SP of the interference section A1 (e.g., one meter before the upstream end SP), it requests entry permission into the interference section A1 from the traveling vehicle controller 3 (step S1). The traveling vehicle controller 3, from which the entry permission has been requested, checks the number of traveling vehicles 5 present in the lock section A2. When having confirmed that the number of traveling vehicles 5 present in the lock section A2 is zero, the traveling vehicle controller 3 determines that the specified number (N = 3) has not been reached (step S2). The traveling vehicle controller 3 permits a traveling vehicle 5 to enter the interference section A1 without checking the presence or absence of traveling vehicles 5 in the interference section A1 (step S3). The traveling vehicle 5 that has entered the interference section A1 exits the interference section A1 and then stops in the lock section A2 before the branch point BP and requests entry permission into the blocking area BA from the traveling vehicle controller 3 (step S4).

When the second traveling vehicle 5 following the first traveling vehicle 5 approaches the upstream end SP of the interference section A1 (e.g., one meter before the upstream end SP), it requests entry permission into the interference section A1 from the traveling vehicle controller 3 (step S5). The traveling vehicle controller 3, from which the entry permission has been requested, checks the number of traveling vehicles 5 present in the lock section A2. When having confirmed that the number of traveling vehicles 5 present in the lock section A2 is one for the first traveling vehicle 5, the traveling vehicle controller 3 determines that the specified number (N = 3) has not been reached (step S6). The traveling vehicle controller 3 permits the second traveling vehicle 5 to enter the interference section A1 without checking the presence or absence of traveling vehicles 5 in the interference section A1 (step S7). The second traveling vehicle 5 that has entered the interference section A1 exits the interference section A1 and then stops in front of the first traveling vehicle 5. The area where the second traveling vehicle 5 stops is also the lock section A2 (step S8).

When the third traveling vehicle 5 following the second traveling vehicle 5 approaches the upstream end SP of the interference section A1 (e.g., one meter before the upstream end SP), it requests entry permission into the interference section A1 from the traveling vehicle controller 3 (step S9). The traveling vehicle controller 3, from which the entry permission has been requested, checks the number of traveling vehicles 5 present in the lock section A2. When having confirmed that the number of traveling vehicles 5 present in the lock section A2 is two for the first traveling vehicle 5 and the second traveling vehicle 5, the traveling vehicle controller 3 determines that the specified number (N = 3) has not been reached (step S10). The traveling vehicle controller 3 permits the third traveling vehicle 5 to enter the interference section A1 without checking the presence or absence of traveling vehicles 5 in the interference section A1 (step S11). The third traveling vehicle 5 that has entered the interference section A1 exits the interference section A1 and then stops in front of the second traveling vehicle 5. The area where the third traveling vehicle 5 stops is also the lock section A2 (step S12).

When the fourth traveling vehicle 5 following the third traveling vehicle 5 approaches the upstream end SP of the interference section A1 (e.g., one meter before the upstream end SP), it requests entry permission into the interference section A1 from the traveling vehicle controller 3 (step S13). The traveling vehicle controller 3, from which the entry permission has been requested, checks the number of traveling vehicles 5 present in the lock section A2. When having confirmed that the number of traveling vehicles 5 present in the lock section A2 is three for the first traveling vehicle 5, the second traveling vehicle 5, and the third traveling vehicle 5, the traveling vehicle controller 3 determines that the specified number (N = 3) has been reached (step S14). The traveling vehicle controller 3 does not permit the fourth traveling vehicle 5 to enter the interference section A1 (step S15). After this, the fourth traveling vehicle 5 periodically requests entry permission into the interference section A1 from the traveling vehicle controller 3 until it is permitted to enter by the traveling vehicle controller 3.

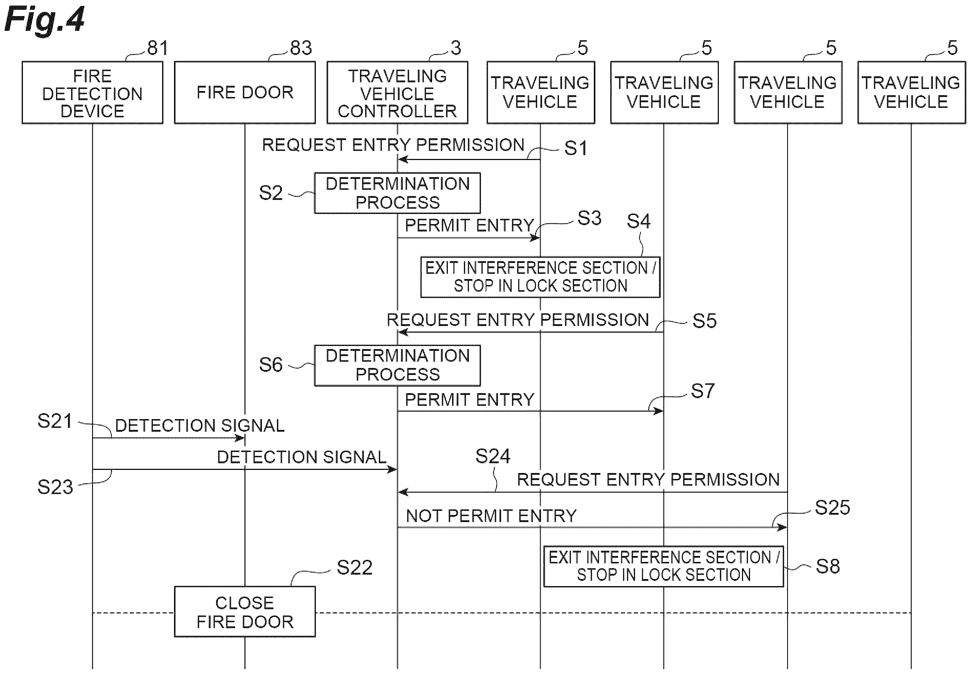

In the traveling vehicle system 1 thus configured, operation of each traveling vehicle 5 when the fire detection device 81 has detected a fire when the traveling vehicle controller 3 allows the traveling vehicle 5 to enter the interference section A1 will be described below mainly with reference to FIG. 4. Step S1 to step S8 therein are the same as those in FIG. 3, and thus a detailed description thereof is omitted. The following describes operation of the above-described third traveling vehicle 5, assuming that the fire detection device 81 has detected a fire after the second traveling vehicle 5 has stopped in the lock section A2.

When having detected a fire, the fire detection device 81 transmits a detection signal to the fire door 83 (step S21) and also transmits the detection signal to the traveling vehicle controller 3 (step S23). The fire door 83 completes advancing to the advance position 30 seconds after receiving the detection signal transmitted from the fire detection device 81 (step S22). Before the fire detection device 81 detects the fire, the second traveling vehicle 5 that had entered the interference section A1 has exited the interference section A1 and stops in the lock section A2 before the fire door 83 advances (CLOSE) to the advance position (step S8).

When the third traveling vehicle 5 following the second traveling vehicle 5 approaches the upstream end SP of the interference section A1 (e.g., one meter before the upstream end SP), it requests entry permission into the interference section A1 from the traveling vehicle controller 3 (step S24). After receiving the detection signal from the fire detection device 81, the traveling vehicle controller 3 does not permit entry into the interference section A1 even if entry permission is requested from the traveling vehicle 5. In other words, even if entry permission is requested from the third traveling vehicle 5, the traveling vehicle controller 3 after step S24 does not permit it to enter the interference section A1 (step S25). After this, the third traveling vehicle 5 periodically requests entry permission into the interference section A1 from the traveling vehicle controller 3 until it is permitted to enter by the traveling vehicle controller 3.

The operation and effect of the traveling vehicle system 1 in the above-described embodiment will be described. In the traveling vehicle system 1 according to the above embodiment, traveling vehicles 5 are permitted to continuously enter the interference section A1 without checking the presence or absence of traveling vehicles 5 in the interference section A1 until the number of traveling vehicles 5 present in the lock section A2 reaches the specified number N. In the traveling vehicle system 1 according to the above embodiment, when the number of traveling vehicles 5 present in the lock section A2 has reached the specified number N, traveling vehicles 5 are prohibited from entering the interference section A1. By this control, a traveling vehicle 5 that cannot enter the lock section A2 from the interference section A1 will not stay in the interference section A1, and the activated fire door 83 can be prevented from catching the traveling vehicle 5. Consequently, the activated fire door 83 can function properly while suppressing a reduction in transport efficiency.

In the traveling vehicle system 1 according to the above embodiment, the traveling vehicle controller 3 permits the traveling vehicles 5 to enter the interference section A1 without checking the presence or absence of the traveling vehicles 5 in the interference section A1. By this control, the number of traveling vehicles 5 that are allowed to enter the interference section A1 per unit of time can be increased in comparison with conventional blocking control of checking the presence or absence of the traveling vehicles 5 in the interference section A1 and then allowing the traveling vehicles 5 to enter the interference section A1.

In the traveling vehicle system 1 according to the above embodiment, the fire door 83 has a time lag between shutting off the traveling area of the traveling vehicles 5 and detecting the anomaly, and the interference section A1 is set so that the traveling vehicles 5 are able to travel through the interference section A1 during the time lag (the distance, the upstream end position, the downstream end position, and the like of the interference section A1 are set). By this configuration, when an anomaly has been detected while a traveling vehicle 5 is passing through the interference section A1, the traveling vehicle 5 can be more reliably ejected from the interference section A1.

In the traveling vehicle system 1 according to the above embodiment, a deceleration point for the traveling vehicles 5 or a stop point for the traveling vehicles 5 is set on the track 11 downstream in the one direction from a portion of the traveling area shut off by the fire door 83, and the lock section A2 is set to be a section between the boundary (the boundary between the interference section A1 and the lock section A2, which is the downstream end position of the interference section A1) and the deceleration point or a section between the boundary and the stop point. By this configuration, even when the point where congestion of traveling vehicles 5 is likely to occur is located downstream of the portion shut off by the fire door 83, the activated fire door 83 can function properly while suppressing the reduction in transport efficiency.

In the traveling vehicle system 1 according to the above embodiment, the deceleration point or the stop point is set at each branch point BP where the corresponding track 11 branches into two or more. By this configuration, even when the branch point BP where congestion of the traveling vehicles 5 is likely to occur is located downstream of the portion shut off by the fire door 83, the activated fire door 83 can function properly while suppressing the reduction in transport efficiency.

Although an embodiment has been described above, an aspect of the present invention is not limited to the above-described embodiment. Various modifications can be made without departing from the gist of the invention.

In the traveling vehicle system 1 according to the above embodiment, an example has been described in which the traveling vehicle controller 3 permits the traveling vehicles 5 to continuously enter the interference section A1 without checking the presence or absence of traveling vehicles 5 in the interference section A1 until the number of traveling vehicles 5 present in the lock section A2 reaches the specified number N of three. However, the above specified number N only needs to be two or more, and may be two or may be four or more.

In the traveling vehicle system 1 according to the above embodiment, an example has been described in which a portion of the traveling area for the traveling vehicles 5 in the interference section A1 is shut off by the fire door 83. However, for example, a track portion forming the interference section A1 may be configured to be capable of retreating. Specifically, the track portion capable of retreating retreats from its normal position to a retreat position to avoid contact with the fire door 83 when the fire door 83 is activated. Even in the traveling vehicle system 1 thus configured, a portion of the traveling area for the traveling vehicles 5 is shut off by the fire door 83 that is activated upon detection of an anomaly has been detected by the fire detection device 81.

In the traveling vehicle system 1 according to the embodiment and the modifications described above, the overhead traveling vehicle 5 has been described as an example of the traveling vehicle. However, other examples of the traveling vehicle include an automated traveling vehicle configured to travel on a track installed on the ground or a frame.

The technical subject matter of the aspect of the present invention may be described as follows.
[1] A traveling vehicle system comprising:
   a track;
   a plurality of traveling vehicles configured to travel along the track in one direction; and
   a control unit configured to control each of the traveling vehicles, wherein
   a portion of a traveling area for the traveling vehicles is shut off by a shutter configured to be activated upon detection of an anomaly by a detection device,
   the control unit:
      sets as an interference section a section of the track that includes at least a presence area of the traveling vehicles with which the shutter activated upon detection of the anomaly comes into contact;
      sets as a lock section a section being adjacent downstream of the interference section in the one direction and having a section length in which two or more of the traveling vehicles are able to be present;
      further permits the traveling vehicles to enter the interference section upon determining that the number of the traveling vehicles present in the lock section has not reached a specified number of two or more; and
      prohibits the traveling vehicles from entering the interference section upon determining that the specified number has been reached.
[2] The traveling vehicle system according to [1], wherein the control unit permits the traveling vehicles to enter the interference section without checking the presence or absence of the traveling vehicles in the interference section.
[3] The traveling vehicle system according to [1] or [2], wherein
   the shutter has a time lag between shutting off the traveling area and detecting the anomaly, and
   the interference section is set so that the traveling vehicles are able to travel through the interference section during the time lag.
[4] The traveling vehicle system according to [3], wherein
   a boundary between the interference section and the lock section is set at a position where the traveling vehicles are able to travel through the interference section during the time lag,
   a deceleration point for the traveling vehicles or a stop point for the traveling vehicles is set on the track further downstream in the one direction than a portion of the traveling area shut off by the shutter, and
   the lock section is set to be a section between the boundary and the deceleration point or a section between the boundary and the stop point.
[5] The traveling vehicle system according to [4], wherein the deceleration point or the stop point is set at a branch point where the track branches in two or more directions.
[6] The traveling vehicle system according to any one of [1] to [5], wherein the detection device is a fire detection device configured to detect a fire, and the shutter is a fire door.

### Reference Signs List

- 1: traveling vehicle system
- 3: traveling vehicle controller (control unit)
- 5: overhead traveling vehicle (traveling vehicle)
- 11: track
- 40: traveling vehicle control unit
- 81: fire detection device (detection device)
- 83: fire door (shutter)
- A1: interference section
- A2: lock section
- BA: blocking area
- BP: branch point
- CP: merging point
- EA: presence area

## Claims

1. A traveling vehicle system comprising:
a track;
a plurality of traveling vehicles configured to travel along the track in one direction; and
a control unit configured to control each of the traveling vehicles, wherein
a portion of a traveling area for the traveling vehicles is shut off by a shutter configured to be activated upon detection of an anomaly by a detection device,
the control unit:
sets as an interference section a section of the track that includes at least a presence area of the traveling vehicles with which the shutter activated upon detection of the anomaly comes into contact;
sets as a lock section a section being adjacent downstream of the interference section in the one direction and having a section length in which two or more of the traveling vehicles are able to be present;
further permits the traveling vehicles to enter the interference section upon determining that the number of the traveling vehicles present in the lock section has not reached a specified number of two or more; and
prohibits the traveling vehicles from entering the interference section upon determining that the specified number has been reached.

2. The traveling vehicle system according to claim 1, wherein the control unit permits the traveling vehicles to enter the interference section without checking the presence or absence of the traveling vehicles in the interference section.

3. The traveling vehicle system according to claim 1 or 2, wherein
the shutter has a time lag between shutting off the traveling area and detecting the anomaly, and
the interference section is set so that the traveling vehicles are able to travel through the interference section during the time lag.

4. The traveling vehicle system according to claim 3, wherein
a boundary between the interference section and the lock section is set at a position where the traveling vehicles are able to travel through the interference section during the time lag,
a deceleration point for the traveling vehicles or a stop point for the traveling vehicles is set on the track further downstream in the one direction than a portion of the traveling area shut off by the shutter, and
the lock section is set to be a section between the boundary and the deceleration point or a section between the boundary and the stop point.

5. The traveling vehicle system according to claim 4, wherein the deceleration point or the stop point is set at a branch point where the track branches in two or more directions.

6. The traveling vehicle system according to claim 1 or 2, wherein the detection device is a fire detection device configured to detect a fire, and the shutter is a fire door.
